# EUROPÄISCHE PATENTANMELDUNG

(11) **EP 1 135 013 A1**
(43) Veröffentlichungstag der Anmeldung: **19.09.2001**
(21) Anmeldenummer: 00105540.9
(22) Anmeldetag: 16.03.2000
(51) Int. Cl.: H05K 5/00, H04M 1/02

(54) **Türstation**

(71) Anmelder: A. Grothe & Söhne GmbH & Co. KG, 53773 Hennef (DE)
(72) Erfinder: Kuchem, Hubert, 53332 Bornheim (DE); Dahl, Jürgen, 51377 Leverkusen (DE); Wudke, Peter, 50997 Köln (DE); Fahnemann, Ullrich, 53639 Königswinter (DE); Böser, Werner, 53909 Zülpich (DE); Oster, Axel, 53721 Siegburg-Heide (DE)
(74) Vertreter: Kluin, Jörg-Eden, Dr. Dipl.-Phys.

(57) **Zusammenfassung**

Türstation einer aus Türstationen und Wohnungsstationen in einem Gebäude zu bildenden Türanlage mit mehreren Funktionsmodulen, die jeweils zumindest ein Funktionselement - wie Klingeltaster, Lautsprecher, Mikrofon, Videokamera, Bewegungsmelder - sowie mechanische Verbindungselemente und elektrische Verbindungselemente umfassen und die jeweils eine Modulbasis, eine Leiterplatte, eine Frontplatte und ggfs. einen Trägereinsatz umfassen, wobei die Funktionsmodule in Aufsicht rechteckig, insbesondere quadratisch sind und Umfangskanten gleicher Höhe aufweisen und mit den mechanischen Verbindungselementen mit ihren Umfangskanten aneinander grenzend zu einer selbsttragenden Einheit aus in Zeilen und/oder Spalten angeordneten Funktionsmodulen verbindbar sind, und wobei die Funktionsmodule Befestigungsmittel zur unmittelbaren Befestigung der Einheit an einem gebäudeseitigen ortsfesten Wandelement - Mauerwerk mit Aufputz, Umrahmung einer Haustüranlage - aufweist.

## Beschreibung

Die Erfindung betrifft eine Türstation einer aus Türstationen und Wohnungsstationen in einem Gebäude zu bildenden Türanlage mit Gegensprechfunktionen und gegebenenfalls weiteren Überwachungsfunktionen. Hierbei können von einer Wohnungsstation mehrere Türstationen wahlweise geschaltet werden, insbesondere in Einfamilienhäusern, oder es können von einer Türstation aus mehrere Wohnungsstationen aufrufbar sein, insbesondere in Mietshäusern.

Es ist bekannt, solche Türstationen aus mehreren Funktionsmodulen zusammenzusetzen, die jeweils zumindest ein Funktionselement wie Klingeltaster, Lautsprecher, Mikrofon, Videokamera, Bewegungsmelder oder sonstiges umfassen können. Weiterhin umfassen die Funktionsmodule in bekannter Weise mechanische Verbindungselemente und elektrische Verbindungselemente, die ein Zusammenfügen der Funktionsmodule zu einer aus mehreren Zeilen und/oder Spalten gebildeten Einheit ermöglichen und gleichzeitig ein elektrisches Durchschleifen von entsprechenden elektrischen Leitern bei der Herstellung der Verbindung sicherstellen. Die Funktionsmodule umfassen zumindest eine Modulbasis, die Tragfunktion hat, eine Leiterplatte, auf der eine Elektronik oder dergleichen angeordnet ist, eine Frontplatte, die Schutz- und Dekorfunktion hat, und gegebenenfalls einen Trägereinsatz, der Funktionselemente aufnehmen kann, sofern dieser nicht unmittelbar in der Modulbasis angeordnet sind. Aus der DE 41 34 044 C2 der Anmelderin ist bereits eine Türanlage bekannt, bei der einzelne Funktionsmodule mit Hilfe von Verbindungselementen verbunden sind, die eine Halte- und Tragfunktion erfüllen. Die aus den Funktionsmodulen gebildete Einheit wird als ganzes in einen Aufnahmerahmen eingesetzt, der zuvor oder abschließend mit einem Wandelement des Gebäudes zu vebinden ist.

### Vereinfachter Aufbau

Der vorliegenden Erfindung liegt die Aufgabe zugrunde, eine Türstation der genannten Art mit vereinfachtem Aufbau bereitzustellen. Die Lösung hierfür besteht darin, daß die Funktionsmodule mit den mechanischen Verbindungselementen mit ihren Umfangskanten aneinandergrenzend zu einer selbsttragenden Einheit aus in Zeilen und/oder Spalten angeordneten Funktionsmodulen verbindbar sind, wobei die Funktionsmodule Befestigungsmittel zur unmittelbaren Befestigung der Einheit an einem gebäudeseitigen ortsfesten Wandelement - Mauerwerk mit Aufputz, Umrahmung einer Haustüranlage - aufweisen. Hierbei ist insbesondere vorgesehen, daß ein die Einheit aus der Mehrzahl von Funktionsmodulen einfassender nicht tragender Rahmen unmittelbar mit der Einheit verbindbar ist und auf dem gebäudeseitigen ortsfesten Wandelement verbindungslos aufliegt. Die Befestigungsmittel an den Funktionsmodulen können hierbei insbesondere höhenverbiegbare Laschen mit Schraubenlöchern sein, die es ermöglichen, Unebenheiten des Wandelements, insbesodere wenn es sich um eine Wand mit Aufputz handelt, bei der Montage der Einheit durch Verbiegen beim Anziehen der Befestigungsschrauben zu erleichtern. Mit den hiermit genannten Mitteln ist eine leichtere Handhabung der aus in Zeilen und/oder Spalten angeordneten Funktionsmodulen zusammengesetzten Einheit möglich, wobei in gleicher Weise eine Anbringung auf der Wand oder eine versenkte Anbringung darstellbar ist.

Als geeignete mechanische Verbindungsmittel zur Ausbildung der selbsttragenden vormontierten Einheit aus einer Mehrzahl von Funktionsmodulen sind an den Umfangskanten der Funktionsmodulen angeordnete komplementär ineinandergreifende Laschen und Schlitze bzw. Federn und Nuten geeignet, wobei die hergestellten Verbindungen mit die Laschen durchsetzenden Stiften oder Schrauben gesichert werden können, die in das jeweils mit dem Schlitz oder der Nut versehene Funktionsmodul eingesetzt werden. Eine andere geeignete Art der Verbindungsmittel sind an den Umfangskanten der Funktionsmodulen angeordnete komplementär ineinandergreifende Laschen und Schlitzen bzw. Federn und Nuten, wobei die Verbindungen zwischen den Funktionsmodulen durch in Formvorsprünge an den Laschen greifende Rastklinken gesichert werden können, die an dem jeweils mit dem Schlitz bzw. der Nut versehenen Funktionsmodul vorgesehen sind.

Erst nach vollständiger und sicherer Montage der Einheit aus Funktionsmodulen kann die Umfangsfuge durch einen geeigneten und dem Anwendungsfall angepaßten Rahmen, der unmittelbar mit der Einheit verbunden wird, abgedeckt und verkleidet werden. Da der Rahmen keine Tragfunktion hat, kann er gegebenenfalls weniger stabil ausgeführt werden. Die Gefahr von Beschädigungen des Rahmens, der auch Dekorfunktion hat, wird durch die erst abschließende Montage gering gehalten. Die Verbindung zwischen Rahmen und Einheit aus Funktionsmodulen kann eine nicht ohne weiteres wieder lösbare Schnappverbindung sein.

### Elektrische Verbindungsmittel

Eine weitere Aufgabe liegt darin, die Art der elektrischen Verbindungsmittel zu verbessern und zu vereinfachen. Die Lösung hierfür besteht darin, daß die Leiterplatten der einzelnen Funktionsmodule zumindest an zwei gegenüberliegenden Kanten Steckplätze haben, deren Steckkontakte mit parallelverlaufenden und gedruckten Leitern paarweise miteinander verbunden sind, wobei mit den elektrischen Verbindungsmitteln zwischen den einzelnen Funktionsmodulen eine Busstruktur in Zeilen und/oder in Spalten innerhalb der Einheit herstellbar ist. Eine Alternative hierzu liegt darin, daß die Leiterplatte der einzelnen Funktionsmodule an jeder ihrer Kanten Steckplätze haben, deren Steckkontakte mit kreuzweise verlaufenden zueinander mit ihren Kreuzungspunkten diagonal versetzten gedruckten Leitern quadrupelweise verbunden sind wobei mit den elektrischen Verbindungsmitteln zwischen den einzelnen Funktionsmodulen eine Busstruktur in Zeilen und/oder in Spalten innerhalb der Einheit herstellbar ist. Besonders vorteilhaft ist es, wenn im Zusammenhang mit den vorstehenden Merkmalen auch die Steckkontakte als gedruckte Kontakte auf den Leiterplatten ausgebildet sind und die elektrischen Verbindungsmittel ausschließlich durch symmetrische klemmenartige Leiterplattenverbinder gebildet werden. Hierdurch kann auf Seiten der Funktionsmodule auf jegliche zusätzliche Anbringung von Vielfachsteckern oder Vielfachbuchsen verzichtet werden, womit sich zum einen die Herstellung vereinfacht und verbilligt und zum anderen die Zahl der Fehlerquellen aufgrund wegfallender Löt- oder Schraubverbindungen deutlich reduziert ist. Die entsprechenden Leiterplattenverbinder sind einstückige elastische Kunstsroffteile mit entsprechenden vergossenen Leiterschienen.

Die hier genannten Merkmale lassen sich auch an einer Türstation verwirklichen, bei der die Einheit aus Funktionsmodulen zunächst in einem Gehäuse oder in einem Rahmen verbaut wird, der danach seinerseits unmittelbar an einem Wandelement befestigt wird, wobei die Einheit aus Funktionsmodulen keine unmittelbare Verbindung mit dem Wandelement aufweist.

### Erweiterte Funktionen

Eine weitergehende Aufgabe ist darin zu sehen, eine Türstation der genannten Art mit zusätzlichen neuartigen Funktionen auszustatten. Hierfür ist vorgesehen, daß zumindest ein Funktionsmodul einen Helligkeitssensor und eine Steuerschaltung umfaßt, die helligkeitsabhängig eine Verknüpfung einer Klingelbetätigung an der Einheit mit einer automatischen Betätigung einer zeitgeschalteten Hausbeleuchtung zuschalten oder abschalten kann.

Hiermit wird in vorteilhafter Weise Energie gespart, indem bei Tageslicht eine Betätigung eines Klingelknopfes nicht zur automatischen Einschaltung einer Hausbeleuchtung oder Außenbeleuchtung führt, sondern solches Einschalten nur dann vorgesehen ist, wenn der Helligkeitssensor Dämmerung oder Dunkelheit feststellt. Die Helligkeitsempfindlichkeit der Schaltung kann hierbei in näher zu beschreibender Weise einstellbar sein.

Die vorstehend genannte Funktion kann auch mit dem Funktionsmodul für die Hausbeleuchtung in gleicher Weise verknüpft werden, die dementsprechend durch Drücken eines Lichttasters nur bei Dämmerung oder Dunkelheit in Funktion gesetzt werden könnte und während der Tagesstunden ihrer Funktion entkleidet wäre.

Die gleiche Funktion kann auch mit einem Funktionsmodul mit beleuchtbaren Namensschildern so verwendet werden, daß ein Funktionsmodul einen Helligkeitssensor und eine Steuerschaltung umfaßt, die helligkeitsabhängig die Beleuchtung von Namensschildern an der Einheit zuschalten oder abschalten kann.

Die Einschalt- und Ausschaltwerte können Hysterese aufweisen und unter Berücksichtigung von Sperrzeiten definiert und ab Werk voreingestellt sein, wobei aber die Werte durch den Benutzer nachträglich geändert werden können. Eine Möglichkeit dazu besteht darin, über Betätigung durch einen Taster bei Erreichen eines gewünschten Dämmerungswertes diesen als Schaltwert zu definieren.

Zum Zwecke einer weiteren Verbesserung der Funktion kann ein Funktionsmodul eine Fehlererkennungsschaltung und eine Leuchtanzeige zur Darstellung ordnungsgemäßer Schaltung und/oder zur Darstellung eines Fehlerstatus aufweisen. Hiermit kann zum einen nach dem Zusammenstecken der Einheit aus mehreren Funktionsmodulen angezeigt werden, ob die Module bei der Installation richtig miteinander verbunden sind, ob eventuell vorhandene Konstellationsvorgaben nicht beachtet wurden und insbesondere ob alle Module elektrisch angeschlossen sind. Im einfachsten Fall kann dies durch Leuchten oder Blinken von Leuchtioden an den einzelnen Funktionsmodulen angezeigt werden, wobei zumindest ein Funktionsmodul einen Rücksetzknopf für die Fehlererkennungsschaltung aufweisen sollte, mit dem die Leuchtioden wieder ausgeschaltet werden können. Tritt nun an einem einzigen Modul ein Fehler auf, so sollte dies durch die Fehlererkennungsschaltung und die entsprechende Anzeige individuell angezeigt werden, so daß ein Durchprüfen sämtlicher Funktionsmodule bei Auftreten eines Fehlers überflüssig wird. Wartung und Reparatur werden hiermit wesentlich vereinfacht.

Wenn Fehler auftreten, können diese durch unterschiedliche Impulsgruppen der Leuchtdioden ihrem Typ nach individuell angezeigt werden, so daß jedes Funktionsmodul nur eine Leuchtdiode benötigt.

Im Zusammenhang mit vorstehend genannten Merkmalen kann vorgesehen sein, daß ein Trägereinsatz, der in die Modulbasis eines Funktionsmoduls einsetzbar ist und unmittelbar die Leiterplatte oder die Frontplatte tragen kann, aus transparentem Kunststoff besteht und Lichtleiterfunktion zwischen auf der Leiterplatte befestigten Lichtsensormitteln und einer Lichteintrittsöffnung in der Frontplatte hat bzw. Lichtleiterfunktion zwischen auf der Leiterplatte befestigten Leuchtmitteln und einer Lichtaustrittsöffnung in der Frontplatte hat.

Ein Trägereinsatz kann weiterhin aus einem transparenten Kunststoff bestehen und prismenförmige Reflexionsmittel aufweisen, die eine Lichtversorgung einer Beleuchtung für ein in der Frontplatte eingelassenes Namensschild durch ein auf der Leiterplatte befestigtes Leuchtmittel bewirken.

Die vorstehend genannten Merkmale lassen sich auch an einer Türstation verwirklichen, bei der die Einheit aus Funktionsmodulen zunächst in einem Gehäuse oder in einem Rahmen verbaut wird, der dann seinerseits unmittelbar an einem Wandelement befestigt wird, wobei die Einheit aus Fuktionsmodulen keine unmittelbare Verbindung mit dem Wandelement aufweist.

### Konstruktive Einzeilheiten

Eine weitere Aufgabe besteht darin, die Teilevielfalt zu reduzieren und/oder besondere Betriebsicherheit zu garantieren. Hierfür wird ein Trägereinsatz vorgeschlagen, der eine Mehrzahl von durch Wände bebildeten Aufnahmeabteilen umfaßt, die wahlweise mit verschiedenen Funktionsteilen zur Verwendung in verschiedenen Funktionsmodulen bestückbar sind, so daß mit einem einheitlichen Trägereinsatz, z.B. ein Helligkeitssensormodul oder ein Lautsprechermodul/Mikrofon oder ein Klingeltastermodul/Namensschild gebildet werden kann. Insoweit kann der Trägereinsatz wiederum einen Deckel umfassen, der die eingesetzten Funktionsteile hält oder die eingesetzten Funktionsteile in den Aufnahmeabteilen können verklebt oder vergossen werden.

Umfaßt der Trägereinsatz ein Aufnahmeabteil für einen Lautsprecher, so kann vorgesehen sein, daß der Lautsprecher mit einer Lochplatte abgedeckt wird und daß die Frontplatte als Lochplatte ausgebildet ist, wobei dann die Lochraster der beiden Lochplatten so gegeneinander versetzt sind, daß der Lautsprecher gegen mutwillige Beschädigungen von außen weitgehend gesichert ist.

In einem Trägereinsatz können durch eine elastische Membran nach außen abgedichtete Tasterelemente angeordnet sein, auf denen Tasterknöpfe aufliegen, die von der Frontplatte beweglich gehalten sind. Die elastische Membran kann hierbei im Trägereinsatz eingeklipst oder eingeklebt sein, so daß auch hier ein wirksamer Schutz gegen von außen eindringende Feutigkeit und Schmutz gegeben ist.

Auch die vorstehend genannten Merkmale lassen sich an an einer Türstation verwirklichen, bei der die Einheit aus Funktionsmodulen zunächst in einem Gehäuse oder in einem Rahmen verbaut wird, der dann seinerseits unmittelbar an einem Wandelement befestigt wird, wobei die Einheit aus Fuktionsmodulen keine unmittelbare Verbindung mit dem Wandelement aufweist.

Bei funktionsweise einer Türstation der genannten Art wird nur ein einziges Funktionsmodul über eine Anschlußklemme mit den gebäudeseitigen elektrischen Leitungen verbunden, während die elektrische Verbindung zu den anderen Funktionsmodulen über eingesetzte Verbindungsklemmen hergestellt wird, die insbesodere eine Busstruktur schaffen. Die Busstruktur, sei sie linienförmig, sei sie rasterförmig, überträgt die elektrischen Signale entweder von einem Steckplatz auf den an der gegenüberliegenden Kante einer Leiterplatte liegenden Steckplatz bzw. von einem Steckplatz auf alle drei an den anderen Kanten einer Leiterplatte liegenden bei Vorliegen der elektrischen Verbindungen zwischen den benachbarten Leiterplatten Steckplätze, so daß die Weitergabe der Signale an die anderen Funktionsmodule erfolgt.

Sofern eine Einheit mit nur zeilenförmiger Busstruktur oder nur spaltenförmiger Busstruktur ausgebildet ist, können Steckverbinderbrücken aus zwei miteinander elektrisch verbundenen Steckverbindern zur Verbindung benachbarter Spaltenbusse oder Zeilenbusse an jeweils außenliegenden benachbarten Funktionsmodulen vorgesehen sein.

Das eine Funktionsmodul, das über eine Anschlußklemme mit den gebäudeseitigen elektrischen Leitungen verbunden ist, verarbeitet die Steuersignale der anderen Funktionsmodule und führt bei erstmaliger Inbetriebnahme eine Selbstkonfiguration der gesamten Türstation durch, wobei das erstgenannte Funktionsmodul alle besetzten Modulpositionen der die Einheit bildenden Matrix erkennt und die Typen der vorhandenen Funktionsmodule erkennt.

Nachstehend werden bevorzugte Ausführungsbeispiele der Erfindung anhand der beigefügten Zeichnungen beschrieben.

Hierbei zeigen
- Figur 1: ein erstes Ausführungsbeispiel einer erfindungsgemäßen Türstation auf einem Wandelement montiert in Schrägansicht;
- Figur 2: eine Türstation nach Figur 1 in Rücksansicht;
- Figur 3: eine Türstation nach den Figuren 1 und 2 in Explosionsdarstellung mit teilmontiertem Funktionsmodul;
- Figur 4: zwei Funktionsmodule in Unteransicht auf ihre Modulbasis;
- Figur 5: zwei Einzelheiten einer erfindungsgemäßen Türstation im Schnitt
a) Verbindung Funktionsmodul/Rahmen
b) Verbindung zweier Funktionsmodule
- Figur 6: eine Leiterplatte eines Funktionsmoduls einer erfindungsgemäßen Türstation in Schrägansicht;
- Figur 7: eine Leiterplatte nach Figur 6 in ihrem Schaltbild;
- Figur 8: ein einzelnes Funktionsmodul in Explosionsdarstellung ohne Trägereinsatz;
- Figur 9: ein Funktionsmodul mit mehreren Namenschildern im Schnitt;
- Figur 10: ein Funktionsmodul mit einem Lichtsensorelement und mit einer Fehleranzeige im Schnitt;
- Figur 11: ein Funktionsmodul mit einem Klingeltaster und einem beleuchteten Namensschild im Schnitt;
- Figur 12: ein Funktionsmodul mit einem Lautsprecher und einem Mikrofon im Schnitt;
- Figur 13: einen Klemmenanschluß für eine Türstation der genannten Art;
- Figur 14: eine erfindungsgemäße Türstation einer zweiten Art auf einem Wandelement in Schrägansicht;
- Figur 15: die Türstation nach Figur 14 in Explosionsdarstellung;
- Figur 16: die Türstation nach den Figuren 14 und 15 im Querschnitt durch das Wandelement;
- Figur 17: eine erfindungsgemäße Türstation in einer dritten Ausführung ohne Rahmen;
- Figur 18: eine Funktionsdarstellung einer Hausanlage mit zwei Türstationen, zwei Videokameras und zwei Hausstationen.

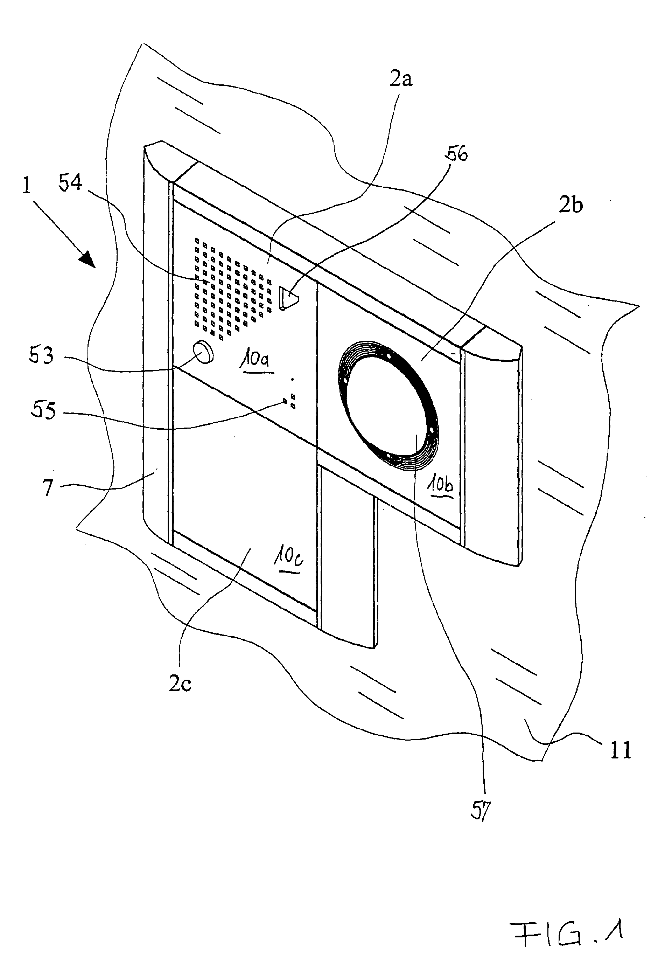

Figur 1 zeigt eine erfindungsgemäße Türstation 1, die aus drei Funktionsmodulen 2a, 2b, 2c L-förmig zusammengesetzt ist und damit eine horizontale Zeile und eine vertikale Spalte umfaßt. Die Türstation ist auf einem Wandelement 11 befestigt, das z.B. Mauerwerk mit Aufputz sein kann oder aber die Umrahmung einer Haustüranlage. Die Frontplatte 10a des ersten Funktionsmoduls zeigt ein Lochfeld 54, hinter dem beispielsweise ein Lautsprecher und ein Mikrofon liegen können, ein zweites kleineres Lochfeld 55, z.B zum Lichtaustritt von Leuchtmitteln sowie eine Durchbrechung 56 z.B. zum Lichteintritt für einen Lichtsensor. Weiterhin ist ein Klingeltaster 53 gezeigt. Die Frontplatte 10b des zweiten Funktionsmoduls zeigt die Optik 56 einer Videokamera; schließlich ist die Frontplatte 10c des dritten Funktionsmoduls ein geschlossenes Abdeckblech, so daß dieses Modul z.B. das Anschluß und Steuermodul sein kann.

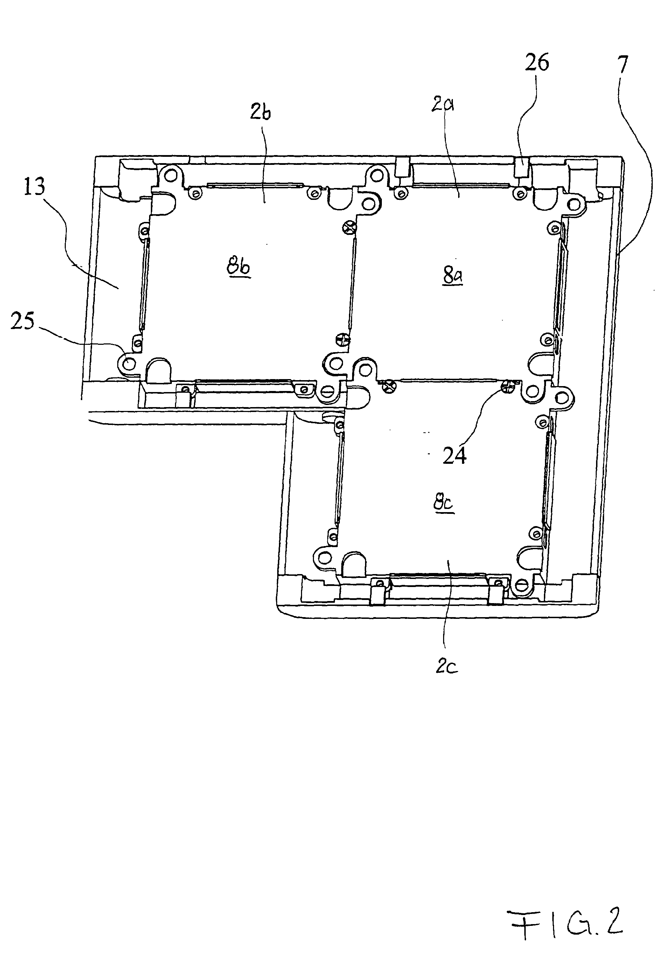

In Figur 2 sind die drei Funktionsmodule 2a, 2b, 2c mit dem einfassenden Rahmen 7 von der Rückseite gezeigt. Hierbei ist jeweils die Modulbasis 8a, 8b, 8c sichtbar. Befestigungsschrauben 24 sind in die Modulbasis jeweils an aneinandergrenzenden Kanten der Funktionsmodule eingeschraubt. Jedes der Funktionsmodule hat an den Ecken befindliche Befestigungslaschen 25 zur unmittelbaren Befestigung der Einheit aus den Funktionsmodulen auf einer Wand. In gegenüberliegenden Außenkanten der Einheit aus Funktionsmodulen sind Halteklammern 26 eingesetzt, auf denen der Rahmen 7 eingerastet ist.

In Figur 3 ist die Türstation nach Figur 1 in Explosionsdarstellung unter Weglassung der Frontplatten und von später noch zu erläuternden Trägereinsätzen gezeigt. Der Rahmen ist in seine Einzelteile 7a bis 7f zerlegt gezeigt. Weiterhin sind die drei Modulbasen 8a, 8b, 8c mit jeweil eingesetzter Leiterplatte 9a, 9b, 9c voneinander getrennt erkennbar. Weitere übereinstimmende Einzelheiten an den Modulen werden weiterhin jeweils nur einmal bezeichnet. An den Außenkanten der Modulbasen sind Federn oder Nocken 22 und Schlitze oder Nockenaufnahmen 23 paarweise vorgesehen, die komplementär ineinandergreifen können und mit den zuvor bezeichneten Befestigungsschrauben 24 zur Verbindung benachbarter Moduleinheiten dienen. An den Eckbereichen der Modulbasen 8 sind die Befestigungslaschen 25 sichtbar. Weiterhin sind die Halteklammern 26 aus Federblech erkennbar, die in die Außenkanten der Modulbasen eingeschoben sind. An der Leiterplatte 9a ist eine Anschlußklemme 12 zum Aufschieben auf einen ersten Steckplatz 16 gezeigt; jeweils zwischen den Leiterplatten 9a, 9b sowie 9a, 9c befindet sich eine Verbindungsklemme 15 in Form eines Leiterplattenverbinders, der an den Steckplätzen 16 auf die Kanten der Leiterplatten aufgeschoben wird, wobei er Durchbrechungen in der jeweiligen Modulbasis durchdringt.

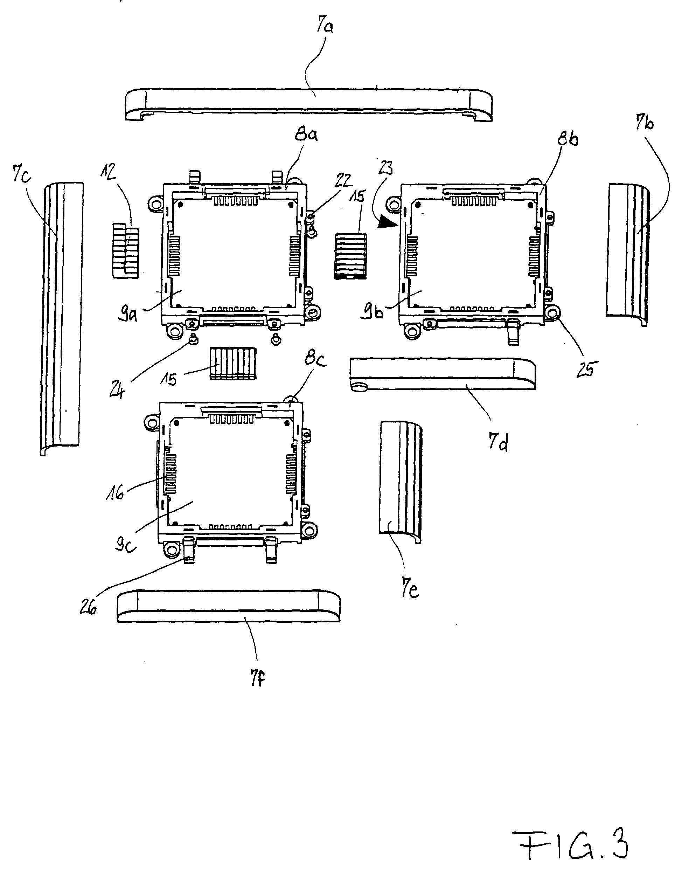

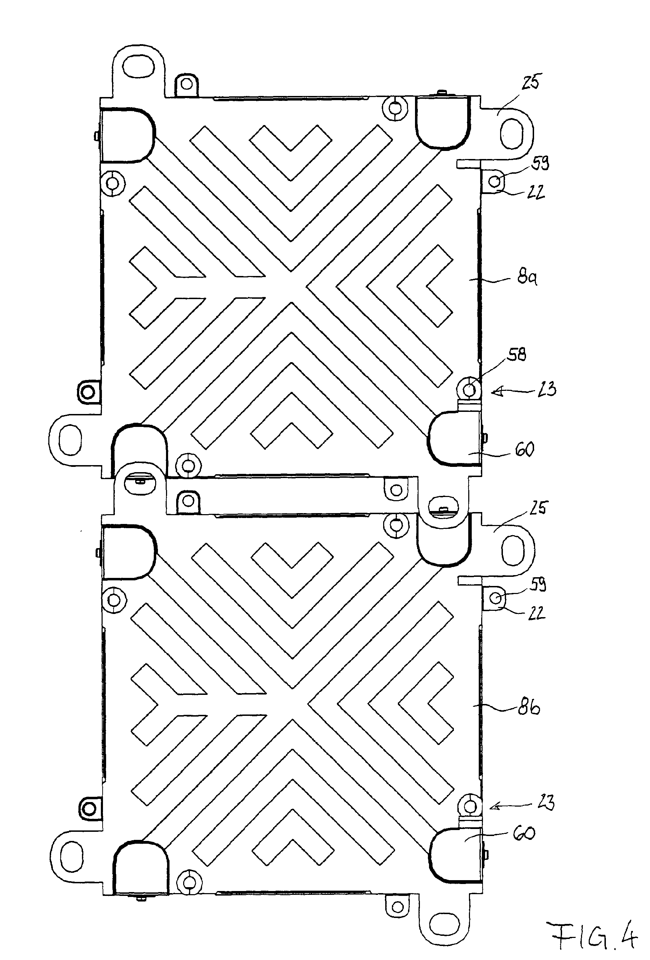

In Figur 4 sind zwei Modulbasen 8a, 8b von der Unterseite gezeigt, wobei an jeder Kante jeweils eine Nocke/eine Feder 22 und eine Nockenaufnahme/ein Schlitz 23 vorgesehen sind. In unmittelbarer Zuordnung zum Schlitz 23 ist jeweils ein Schraubenloch 58 ausgeführt, durch das nach Ineinanderstecken von Nocken und Nockenaufnahmen eine Sicherungsschraube eingedreht werden kann, die dann die Gewindbohrung 59 der entsprechenden Nocke 22 durchdringt. Jeweils in den Eckbereichen der Basisteile 8a, 8b sind Laschen 25 und Taschen 60 ausgebildet, die sich beim Zusammenschieben von zwei Funktionsmodulen ineinandergreifend ergänzen. Zur Befestigung der aus mehreren Funktionsmodulen gebildeten Einheit werden nur die außenliegenden freien Befestigungslaschen 25 verwendet. Die Laschen 25 sind hierbei so ausgebildet, daß sie beim Herstellen der Anschaubung der Einheit an der Wand verbiegbar sind, um Unebenheiten auszugleichen, ohne daß die Gefahr eines Abrechens besteht. Zu diesem Zweck haben sie eine breite Basis und gleichbleibende Breite.

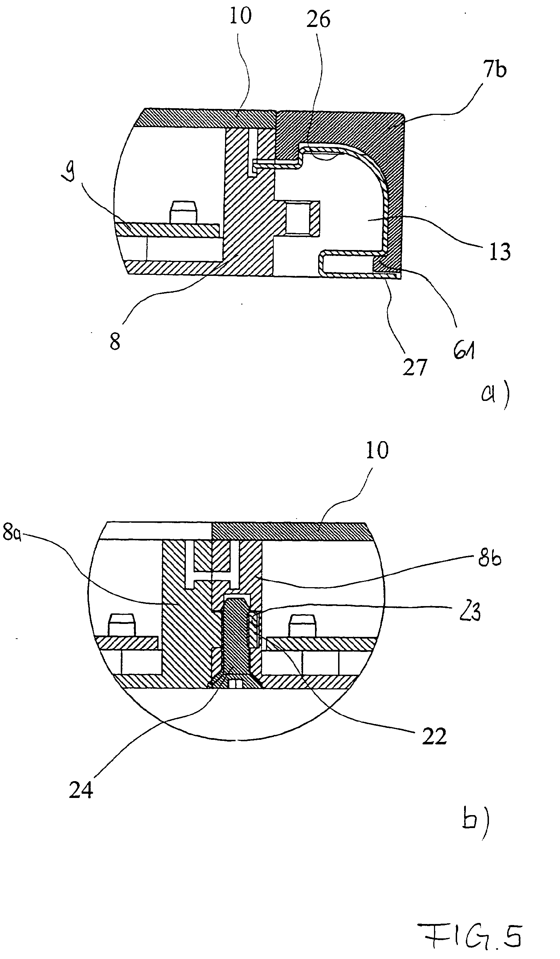

In Figur 5a ist ein Teilquerschnitt durch eine Modulbasis 8 mit einer eingesetzten Leiterplatte 9 und einer aufgesetzten Frontplatte 10 gezeigt. In die Modulbasis 8 ist eine Halteklemme 26 eingesetzt, auf die ein Rahmenteil 7b aufgesetzt ist. Die aus Federstahl bestehende Halteklemme kann beim Aufschieben des Rahmenteils nach innen einfedern, so daß das U-förmig abgebogene Ende 27 der Halteklemme eine Innenkante 61 des Rahmenteils aufnimmt. Im Rahmenteil 7b wird ein Kabelkanal 13 ausgebildet. Das Lösen des Rahmenteils erfordert ein Eindrücken des U-förmig abgebogenen Endes 27 nach innen mit einem Spezialwerkzeug.

In Figur 5b sind zwei Modulbasen 8a, 8b ineinandergesteckt gezeigt, wobei die hier ineinandergreifende Kombination von Nocken 22 und Nockenaufnahme 23 erkennbar wird, die Sicherung erfolgt mittels der eingedrehten Befestigungsschraube 24. Da Nocken 22 und Nockenaufnahme 23 im wesentlichen spielfrei ineinandergreifen, ergibt sich eine selbsttragende Einheit aus mehreren Funktionsmodulen nach dem Eindrehen der Befestigungsschrauben 24.

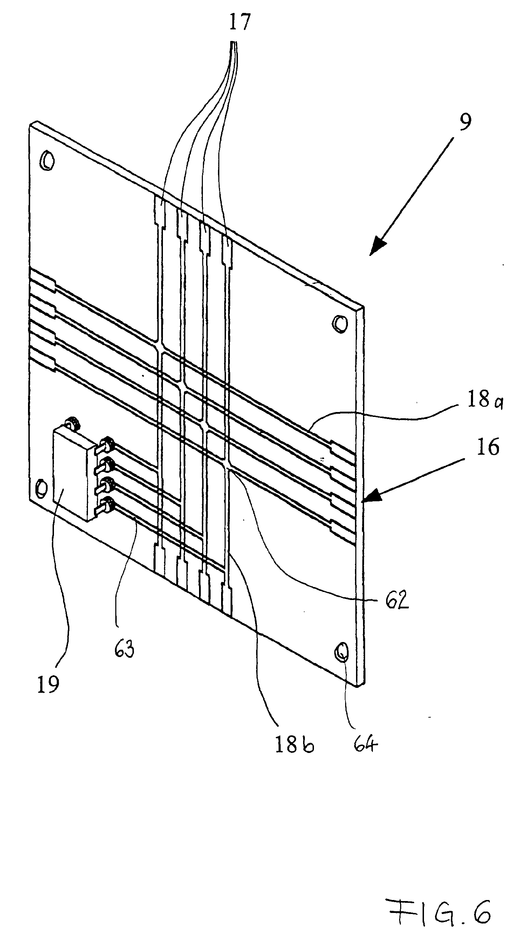

Die Figur 6 zeigt eine Leiterplatte 9 als Einzelheit. Die Leiterplatte ist quadratisch und weist an den vier Kanten Steckplätze 16 auf, die jeweils vier Steckkontakte 17 umfassen. Die einzelnen Steckkontakte 17 sind durch parallel verlaufende und sich kreuzende Leiterbahn 18 miteinander verbunden, deren Kreuzungspunkte 62 zueinander diagonal versetzt sind. Die genannten Kreuzungspunkte stellen elektrische Kontakte dar, während andere Überkreuzungen, die zu sehen sind, gegeneinander elektrisch isoliert sind. Von den vertikal gezeigten Leiterbahnen 18b gehen weitere Leiterbahnen 63 zum Anschluß einer auf der Leiteplatten angebrachten Elektronikeinheit 19. An jedem der vier Steckplätze 16 läßt sich eine Verbindung zu den Kontakten der Elektronik 19 über eine entsprechende Verbindungsklemme oder Anschlußklemme herstellen. Sowohl sämtliche Leiterbahnen 18 als auch die Steckkontakte 17 sind als gedruckte Elemente ausgebildet, so daß zusätzliche Steckerleisten oder Buchsenleisten an den Kanten der Leiterplatte gemäß der Erfindung nicht erforderlich werden. An den Ecken der Leiterplatte sind Bohrungen 64 vorgesehen, die der Befestigung der Leiterplatte in einer Modulbasis dienen. Aufgabe der Elektronik 19 ist es, einzelne Signale des jeweiligen Funktionsmoduls zu verarbeiten und in Steuersignale umzusetzen, für deren Weiterleitung innerhalb der Türstation 1 im Idealfall nur zwei Leiterbahnen 18 nötig sind. Die Elektronik 19 und die besondere Anordnung der Leiterbahnen 18 ermöglichen es somit, daß alle Informationen in einem türstationinternen BUS-System ausgetauscht werden können. Die Elektronik 19 ermöglicht somit die Verwendung der BUS-Technologie, so daß eine Reduzierung der Einzelklemmenzahl möglich ist. Die Anzahl der Anschlüsse ist abhängig von der Anlagen-Komplexität und der Modulvielfalt; im einfachsten Fall sind nur zwei Anschlüsse notwendig, es können jedoch für Zusatzfunktionen (Spannungsversorgung usw.) auch z. B. acht Anschlüsse oder mehr notwendig sein.

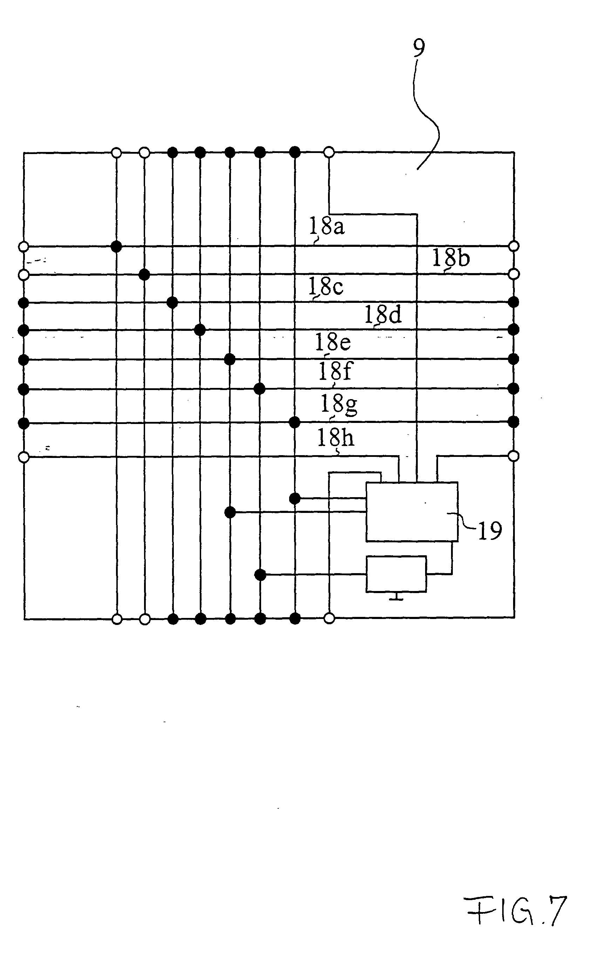

Bei der in Fig. 7 gezeigten Leiterplatte 9 sind besondere Leiterbahnen 18 verwirklicht, nämlich Leiterbahnen 18a und 18b fürdie Weiterleitung eines Sprach-Zweidraht-Bus durch die ganze Türstation bis zu dem Funktionsmodul, das die Signale des Sprach-Zweidraht-Bus verwertet, Leiterbahnen 18c und 18d für die Weiterleitung eines Video-Zweidraht-Bus durch die ganze Türstation bis zu den Funktionsmodulen, die als Videomodule ausgebildet sind, Leiterbahnen 18e und 18f für die Stromversorgung der einzelnen Funktionsmodule, eine Leiterbahn 18g für den Datenaustausch (DATA) eines türstationinternen Bus-System (Kommunikation zwischen den einzelnen Funktionsmodulen) und eine Leiterbahn 18h für die Konfiguration (TEST) und die Erkennung von Funktionsproblemen.

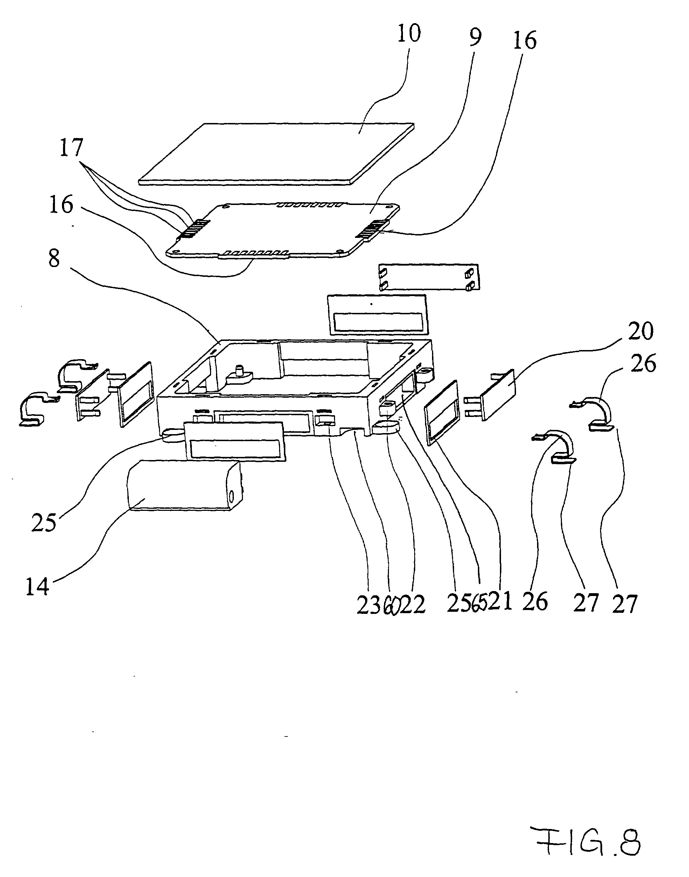

In Figur 8 ist ein einzelnes Funktionsmudul in Explosionsdarstellung gezeigt, wobei im einzelnen Modulbasis 8, Leiterplatte 9, Frontplatte 10 mit den schon beschriebenen Einzelheiten erkennbar ist. Gleiche Einzelheiten sind mit gleichen Bezugsziffern belegt. Im Umfang der Modulbasis sind Durchbrüche 65 erkennbar, die zur Herstellung der elektrischen Steckverbindungen dienen. Die Durchbrüche 65 werden jeweils von einer elastischen Dichtung 21 umrahmt, die insbesondere aufgeklebt ist, wobei ein Verschlußelement bei Nichtbenutzung in die Durchbrechung 65 eingeklipst wird. Auf der vorderen Umfangsfläche ist ein abdichtendes Formteil 14 zur Aufnahme einer Anschlußklemme gezeigt, die im Kabelkanal des Rahmens aufgenommen werden kann.

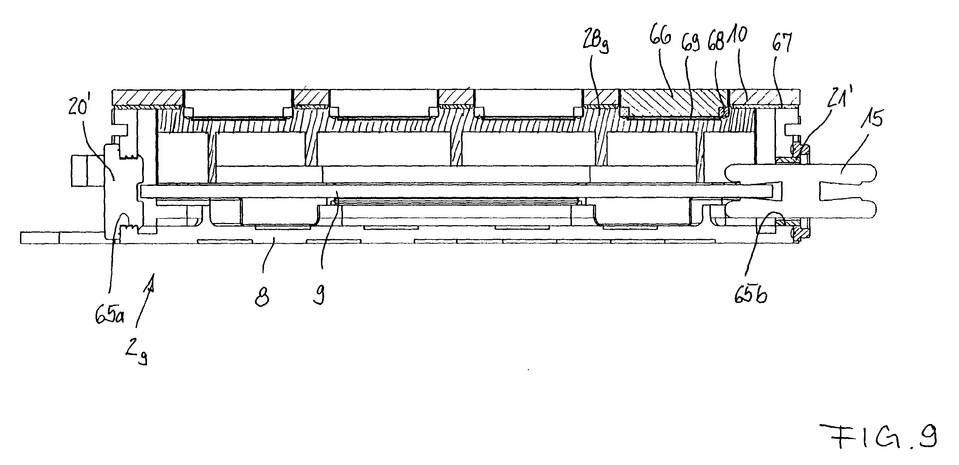

In Figur 9 ist ein Funktionsmodul 2₉ im Schnitt gezeigt, an dem folgende Einzelheiten bezeichnet sind, Modulbasis 8, Leiterplatte 9, Frontplatte 10 sowie ein Trägereinsatz 28₉, der eine Mehrzahl von Namensschildern 66 trägt. Dichtelemente 67, 68, 69 stellen die Abdichtung gegen das Eindringen von Schmutz und Feutigkeit dar. In der Modulbasis 8 sind die Durchbrüche 65a, 65b gezeigt, wobei im ersteren ein hier ganz aus Gummi oder elastischem Kunststoff bestehendes Abschlußelement 20' eingesetzt ist, während im zweiten eine mehrteilige Umfangsdichtung 21 eingesetzt ist, durch die eine Verbindungsklemme 15 in Form eines Leiterplattenverbinders eingesteckt ist. Dies ist im wesentlichen einstückiges Formteil, wobei innenliegende Kontaktstreifen nicht gezeigt sind.

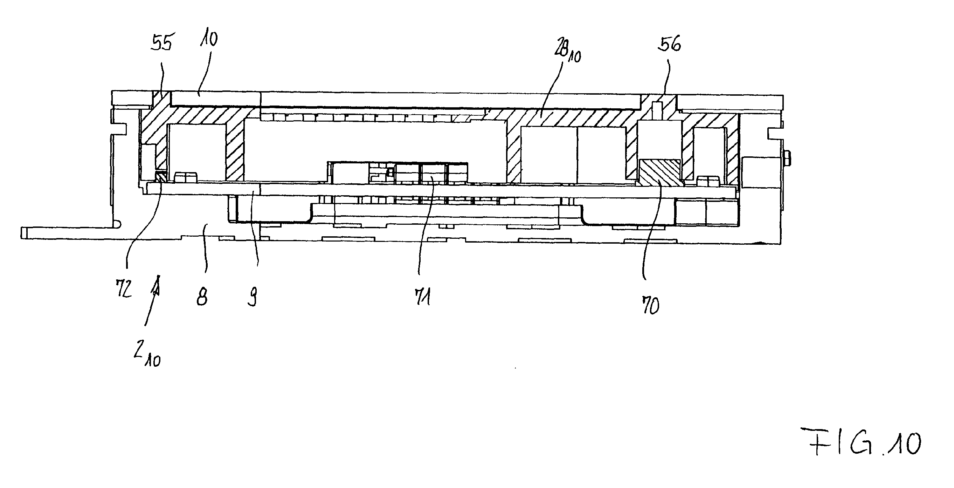

In Figur 10 ist ein Funktionsmodul 2₁₀ gezeigt, an dem als Einzelheiten eine Modulbasis 8, eine Leiterplatte 9 und eine Frontplatte 10 erkennbar sind. Weiterhin ist ein Trägereinsatz 28₁₀ vorgesehen, der aus transparentem Material besteht und die Frontplatte an zwei Stellen durchsetzt. Auf der rechten Seite ist auf der Leiterplatte 9 ein Lichtsensor 70 angeordnet, der über den Durchbruch 65 in der Frontplatte mit Licht versorgt wird, wobei der Trägereinsatz 28₁₀ das innere des Moduls abdichtet. Der Lichtsensor 70 ist mit einer Auswertelektronik 71 elektrisch verbunden. Auf der linken Seite ist auf der Leiterplatte 9 ein Leuchtmittel, insbesondere eine Leuchtdiode 72 angeordnet, die über eine Durchbrechung 55 in der Frontplatte 10 abstrahlen kann, wobei das Material des Trägereinsatzes 28₁₀ als Lichtleiter wirkt.

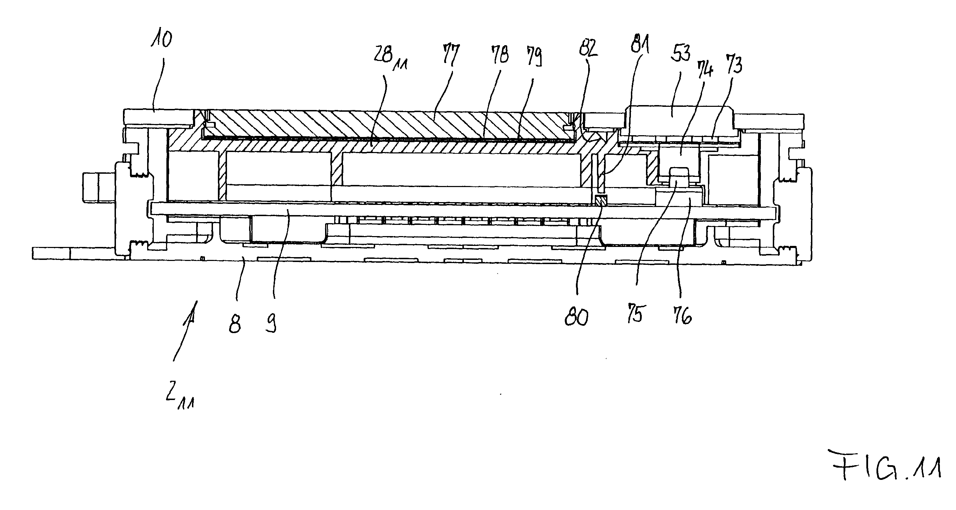

In Figur 11 ist Funktionsmodul 2₁₁ gezeigt, an dem als Einzelheiten eine Modulbasis 8, eine Leiterplatte 9 und eine Frontplatte 10 zu identifizieren sind. Ein Trägereinsatz 28₁₁, der wiederum aus transparentem Material besteht, ist hinter der Frontplatte 10 gehalten, die zwei Durchbrechungen aufweist. In einer ersten Durchbrechung ist ein Klingeltaster 53 beweglich gehalten, der gegenüber dem Trägereinsatz 28₁₁ durch eine eingesetzte oder eingeklebte Dichtmembran 73 abgedichtet ist. Hinter der Dichtmembran liegt ein Stößel 74 und ein elastisches Element 75, das auf den eigentlichen Tastschalter 76 einwirkt, der auf der Leiterplatte befestigt ist. Durch das elastische Element 75 ist die Verwendung einer Druckfeder zu Rückstellung des Klingeltasters entbehrlich. In einer weiteren Öffnung der Frontplatte 10 ist eine Namensschildabdeckung 77 eingesetzt, die aus transparentem Material besteht und eine strukturierte Rückseite 78 hat. Hinter dieser Rückseite liegt das eigentliche Namensschild 79. Das Namensschild ist beleuchtbar über eine auf der Leiterplatte 9 montierte Leichtiode 80, einen als Lichtleiter wirkenden Wandungsteil 81 des Trägereinsatzes, sowie eine durch eine prismische Ausnehmung gebildete Reflexionsfläche 82 im Trägereinsatz. Die Prismenstruktur dient der Umlenkung des von der Leuchtiode 80 ausgehenden Lichtes.

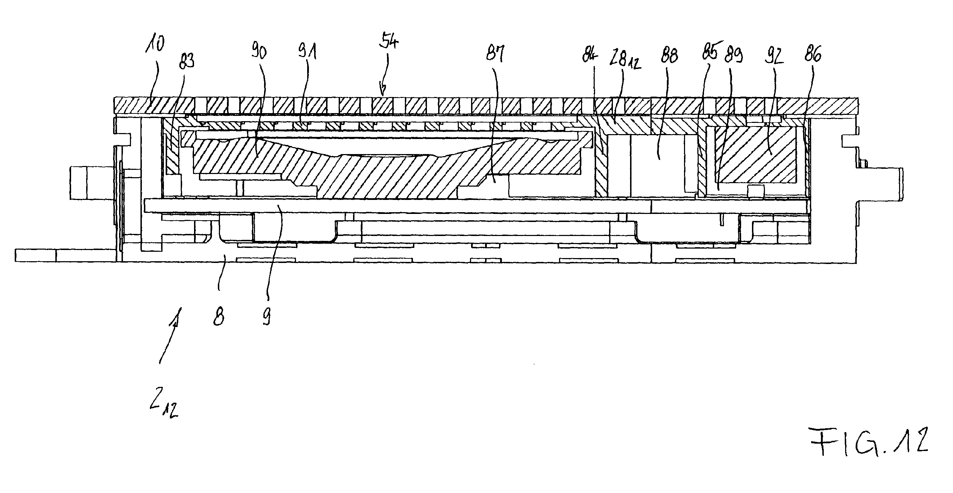

In Figur 12 ist ein Funktionsmodul 2₁₂ gezeigt, an dem als Einzelheiten eine Modulbasis 8, eine Leiterplatte 9 und eine Frontplatte 10 erkennbar sind. Hinter der Frontplatte 10 liegt ein Trägereinsatz 28₁₂, der eine Mehrzahl von Wänden 83, 84, 85, 86 aufweist, die zumindest drei Aufnahmeabteile 87, 88, 89 bilden. Im Aufnahmeabteil 87 ist ein Lautsprecher 90 untergebracht, der mit einem als Lochblech ausgeführten Deckel 91 im Trägereinsatz abgeschlossen ist. Im Aufnahmeabteil 89 ist ein Mikrofon 92 untergebracht. Die Frontplatte hat zumindest ein Lochfeld 54, wobei die Löcher im Deckel 91 und in der Frontplatte 10 so gegeneinander versetzt sind, daß ein mechanischer Schutz des Lautsprechers 90 gegen mutwillige Beschädigung von außen sichergestellt ist.

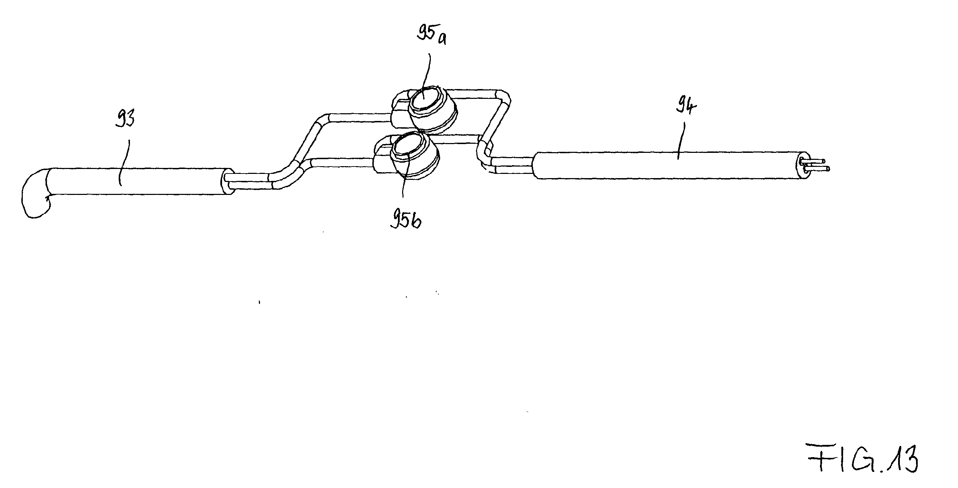

In Figur 13 ist ein gebäudeseitig anzunehmendes zweiadriges Anschlußkabel 93 und ein türstationseitiges Anschlußkabel 94 gezeigt, die mit Quetschverbindern 95 bekannter Bauart schmutz- und feutigkeitssicher verbunden sind, wobei die Größe der Quetschverbinder so ist, daß die Unterbringung im Kabelkanal des Rahmens möglich ist.

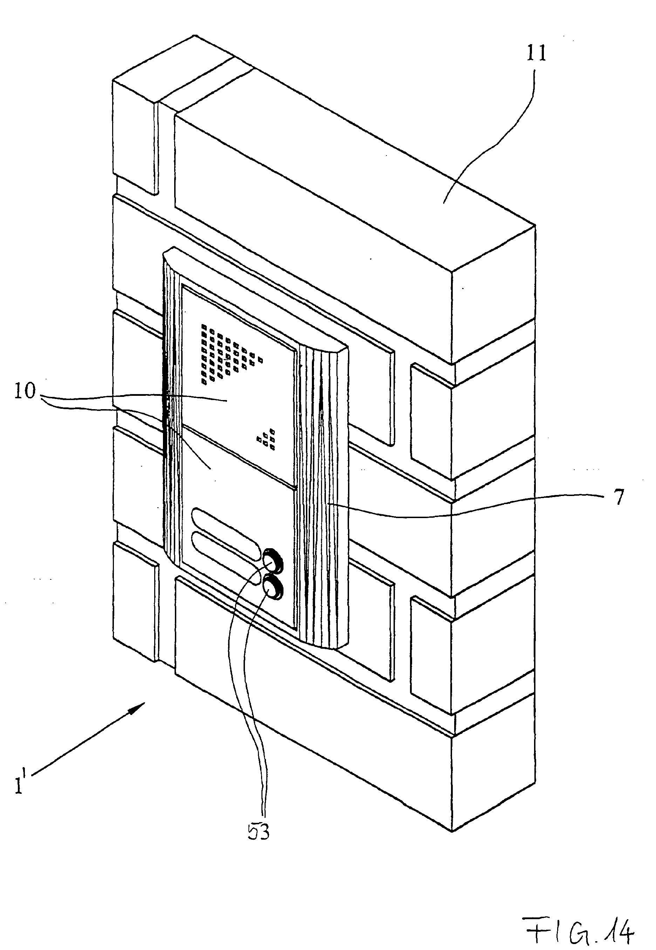

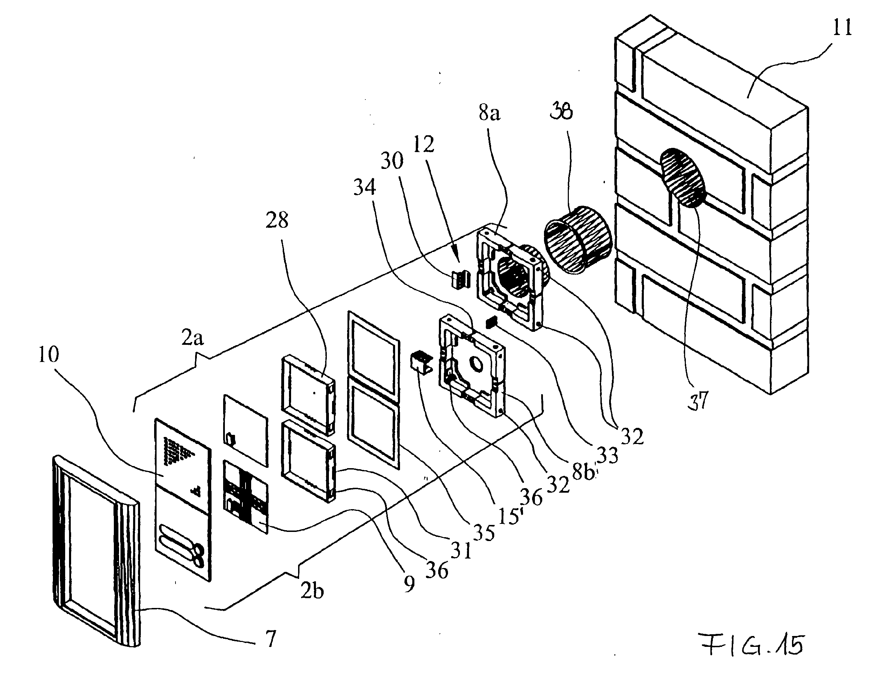

Die Fig. 14-16 zeigen ein zweites Ausführungsbeispiel einer erfindungsgemäßen Türstation 1', einerseits im eingebauten Zustand (Fig. 14), andererseits in Explosionsdarstellung (Fig. 15). Diese Türstation 1 weist nur zwei Funktionsmodule 2a und 2b auf. Dieses Ausführungsbeispiel unterschiedet sich von dem ersten Ausführungsbeispiel im wesentlichen einerseits durch die Befestigung der Leiterplatte 9 und der Abdeckung 10 in dem Basismodul 8, andererseits auch durch die Befestigung der Basismodule 8a und 8b untereinander.

Die Abdeckung 10 und die Leiterplatte 9 werden in einen zusätzlichen Trägereinsatz 28 eingesetzt, und die so entstandene Einheit 29 aus Abdeckung 10, Leiterplatte 9 und Trägereinsatz 28 wird in das Basismodul 8 eingerastet. Die elektrische Verbindung der Türstation 1 mit nicht dargestellten, aus der Wand 11 kommenden elektrischen Leitungen erfolgt ebenfalls dadurch, daß das Funktionsmodul 2a über eine Anschlußklemme 12 mit den elektrischen Leitungen verbunden wird. Hierzu werden die elektrischen Leitungen zunächst durch eine - nicht dargestellte wasserdichte Leitungseinführung in das erste Basismodul 8a gelegt und mit der Anschlußklemme 12 verbunden. Von der Anschlußklemme 12 erfolgt die elektrische Verbindung über Kontaktflächen 30 an dazu korrespondierende Kontaktstifte 31 des Aufnahmerahmens 28. Die elektrische Verbindung des zweiten Funktionsmoduls 2b erfolgt über eine Verbindungsklemme 15 zum ersten Funktionsmodul 2a.

Die mechanische Verbindung zwischen zwei Funktionsmodulen 2a und 2b erfolgt über Rastelemente 32 und ein Verbindungselement 33. Das Verbindungselement 33 wird in in beiden Basismodulen 8a, 8b vorhandene Führungen 34 gesteckt. Die Rastelemente 32 und das Verbindungselement 33 sind so ausgebildet, daß die Basismodule 8a und 8b ggf. leicht wieder voneinander getrennt werden können.

Der Zusammenbau der erfindungsgemäßen Türstation 1' geschieht wie folgt:

Als erstes erfolgt die mechanische Verbindung der beiden Basismodule 8a und 8b. Hierzu werden diese zunächst durch die Rastelemente 32 zusammengesteckt, und dann wird das Verbindungselement 33 in die Führungen 34 eingeschoben. Nach dem Anschluß der - hier nicht dargestellten elektrischen Leitungen - an die Anschlußklemme 12 wird die Anschlußklemme 12 auf eine Seite des Basismoduls 8a aufgesteckt. Anschließend wird die Verbindungsklemme 15' auf nebeneinanderliegende Seiten der Basismodule 8a und 8b - hier auf die untere Seite des Basismoduls 8a und auf die obere Seite des Basismoduls 8b - aufgesteckt.

Im nächsten Schritt wird je eine Dichtung 35 auf das Basismodul 8a bzw. 8b aufgelegt, und danach werden dann die Einheiten 29a bzw. 29b in die entsprechenden Basismodule 8a bzw. 8b eingerastet. Der Einrastmechanismus 36 zwischen der Einheit 29a bzw. 29b und dem Basismodul 8a bzw. 8b ist so ausgebildet, daß einerseits eine sichere Verbindung der Einheit 29a bzw. 29b mit dem Basismodul 8a bzw. 8b gewährleistet ist, andererseits die Verrastung jedoch auch wieder einfach, beispielsweise durch Einschieben einer Schraubendreherspitze, gelöst werden kann. Die aus einer Leiterplatte 9, einer Abdeckung 10 und einem Aufnahmerahmen 28 bestehenden Einheiten 29a, 29b sind vor dem Einsetzen in die Basismodule 8a, 8b zusammengesetzt worden, bzw. werden im zusammengesetzten Zustand vom Hersteller geliefert.

In einem letzten Schritt wird dann der Rahmen 7 montiert, wozu dieser vorzugsweise schräg auf die Oberkante des Basismoduls 8a aufgesetzt, eingehängt und dann in Richtung Wand 11 gedrückt wird. In der Unterseite des Rahmens 7 befindet sich eine - hier nicht dargestellte - Gewindebohrung, so daß der Rahmen 7 abschließend mit einer Schraube an dem Basismodul 8b festgeschraubt werden kann.

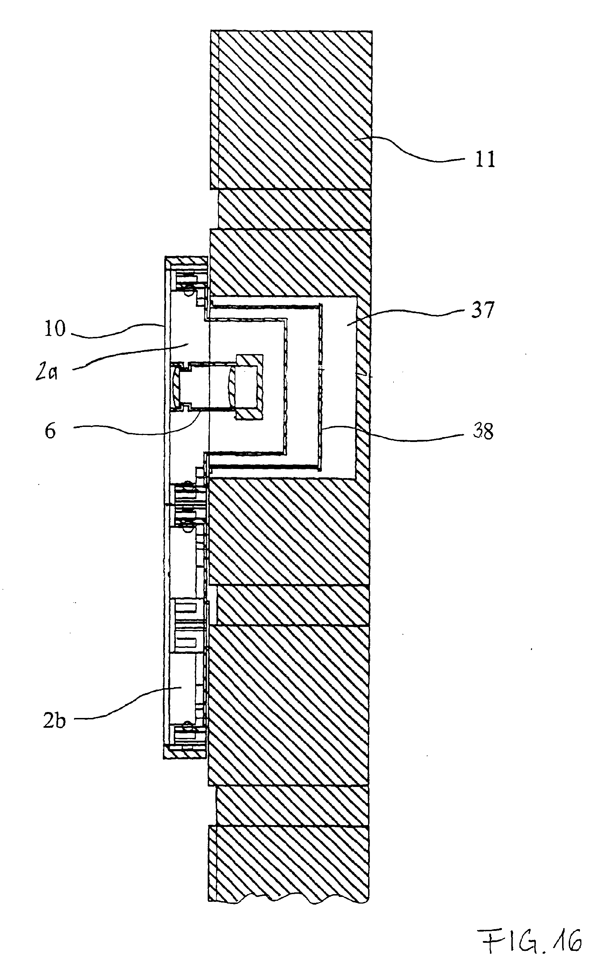

Fig. 16 zeigt die Türstation 1' im eingebauten Zustand mit einem bauartbedingten Funktionsmodul 2a mit größerer Bauhöhe, nämlich für eine Video-Kamera 6. Der für die Video-Kamera 6 benötigte Einbauraum kann nun dadurch auf einfache Art und Weise zur Verfügung gestellt werden, daß mit einer handelsüblichen Bohrkrone ein Loch 37 in die Wand 11 gebohrt wird und anschließend dann eine normale Unterputzdose 38 in dieses Loch 37 eingesetzt und ggf. verputzt wird. Eine normale Unterputzdose 38 bietet dabei ausreichend Platz für das die Video-Kamera 6 aufnehmende Funktionsmodul 2a. Das zweite Funktionsmodul 2b hat die übliche Banhöhe, wie in Figur 15 gezeigt.

Die erfindungsgemäße Türstation 1 bietet also die Möglichkeit, eine Aufputz-Türstation zu realisieren, die lediglich eine "sichtbare" Bauhöhe von maximal 10 bis 20 mm aufweist. Die Türstation 1 ist modulartig aufgebaut, wobei die einzelnen Funktionsmodule und Basismodule sowohl mechanisch als auch elektrisch einfach miteinander verbunden werden können. Oft werden vorhandene Unterputz-Türstationen gegen neue Türstationen ausgetauscht, wobei die alte Türstation häufig eine größere Bauform als die neue Türstation hat. In einem solchen Fall kann das bereits vorhandene größere Loch in der Wand durch eine dem Design der erfindungsgemäßen Türstation angepaßte Abdeckblende überdeckt werden. Auf diese auf der Wand befestigte Abdeckblende wird dann die erfindungsgemäße Türstation aufgeschraubt.

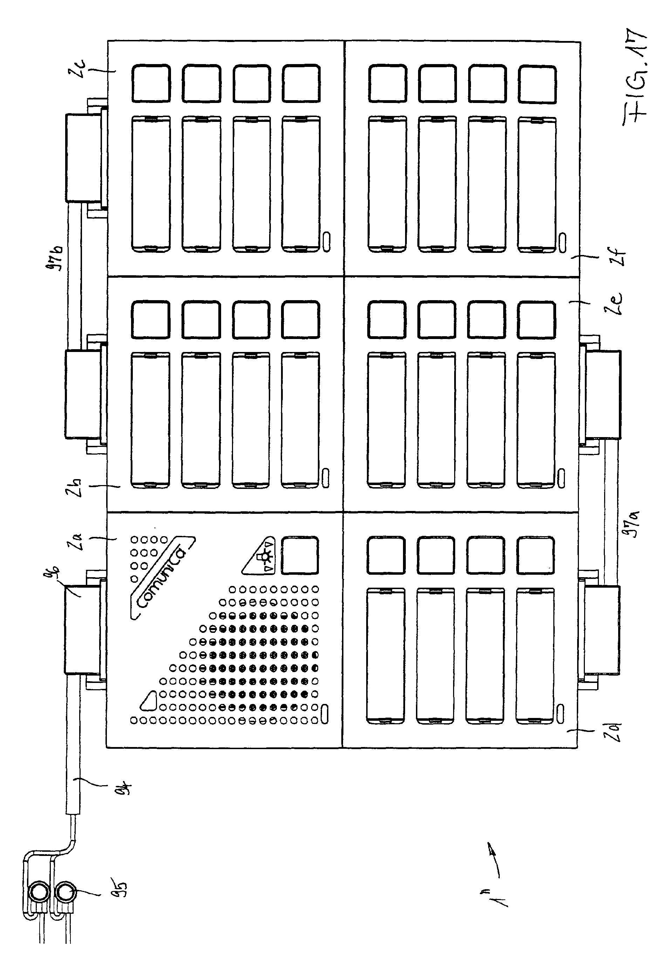

Figur 17 zeigt eine erfindungsgemäße Türstations 1" aus insgesamt sechs Funktionsmodulen 2a-2f, wobei anzunehmen ist, daß Steckplätze nur an den jeweils oben und untenliegenden Kanten der zugehörigen Leiterplatten vorgesehen sind, die über vertikale parallele Leiter miteinander verbunden sind. Aus diesem Grund ist das Funktionsmodul 2a über einen Anschlußstecker 96 mit dem Anschlußkabel 94 verbunden, während die Module 2d und 2e über einen Steckverbinder 97a mit zwei Steckern und die Funktionsmodule 2b, 2c über einen weiteren Steckverbinder 97b mit ebenfalls zwei Steckern extern verbunden sind. Der Anschlußstecker 96 und die Steckverbinder 97a, 97b werden nach Montage im Kabelkanal des des Rahmens aufgenommen. Das Funktionsmodul 2a umfaßt Lichttaster, Mikrofon, Lautsprecher, Lichtsensor und Funktionsanzeigediode, die weiteren Funktionsmodule umfassen jeweils nur Klingeltaster, Namensschilder und Fehleranzeigedioden.

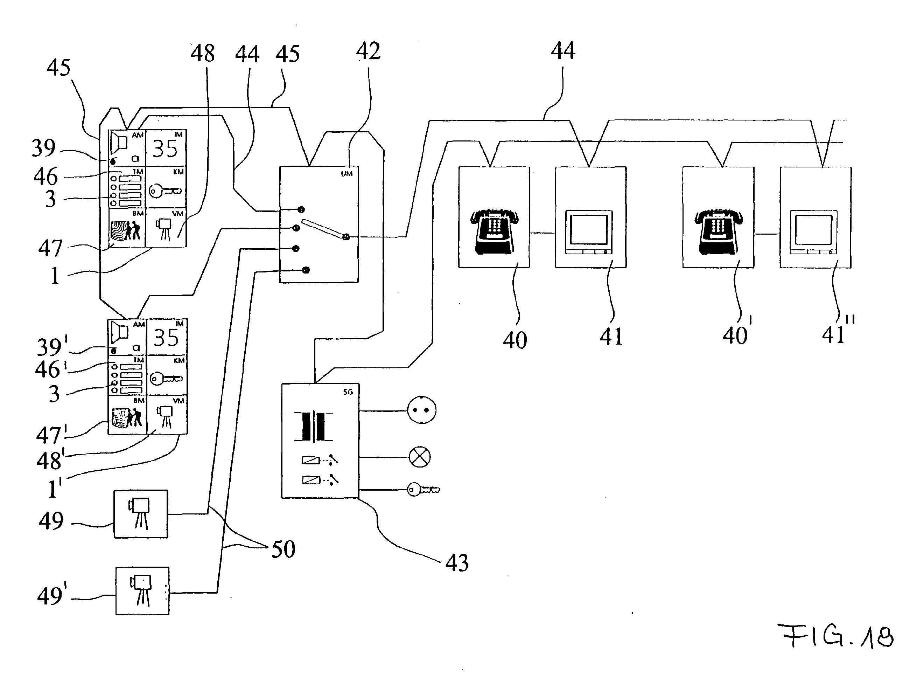

Fig. 18 zeigt eine Funktionsdarstellung zweier Türstationen 1 und 1' im Rahmen einer Hauskommunikationsanlage. Die Hauskommunikationsanlage weist zwei Haustelefone 40, 40', zwei Monitore 41, 41', ein Video-Umschaltmodul 42 und ein Steuergerät 43 auf. Das Steuergerät 43 dient der Stromversorgung der Hauskommunikationsanlage. Die Türstationen 1 und 1' sind über einen Video-Zweidraht-Bus 44 mit den Monitoren 41 bzw. 41' und über einen Sprach-Zweidraht-Bus 45 mit den Haustelefonen 40 bzw. 40' verbunden.

Wichtigstes Element der Türstation 1 bzw. 1' ist das Anschlußmodul 39 bzw. 39'. Das Anschlußmodul 39 bzw. 39' ist das Funktionsmodul, welches über die Anschlußklemme 12 mit den elektrischen Leitungen verbunden wird. Das Anschlußmodul 39 bzw. 39' hat unter anderem die Aufgabe, die Steuersignale aus dem türstationinternen BUS-System in der Elektronik 19 so aufzubereiten, daß sie im Sprach-Zweidraht-Bus 45 bzw. Video-Zweidraht-Bus 44 weitergegeben werden können.

Nachdem die Türstationen 1 und 1' mechanisch und elektrisch fertig installiert sind und Spannung anliegt, führt das Anschlußmodul 39 bzw. 39' eine Selbstkonfiguration aller zur Türstation 1 bzw. 1' gehörenden Funktionsmodule durch und speichert matrixförmig die Position jedes Funktionsmoduls. Dazu sendet es Konfigurations-Signale an seine direkten Nachbarn aus, die von diesen bestätigt werden müssen. Dadurch kennt das Anschlußmodul 39 bzw. 39' seine direkten Nachbarn. Anschließend gibt es die Regie des Konfigurationsvorgangs an seine bereits gefundenen und identifizierten Nachbarn ab, die nun den Konfigurationsprozeß identisch wie zuvor das Anschlußmodul 39 bzw. 39' steuern und ihre Nachbarn anspricht. Das Anschlußmodul 39 bzw. 39' hört die ausgetauschten Informationen auf einer Leiterbahn, der DATA-Leitung, ab und trägt so alle Module in die Kofigurationsmatrix ein.

Im vorliegenden Beispiel hat das Tastenmodul 46 in der Matrix (Zeile, Spalte) die Position (2,1), der Bewegungsmelder 47 die Position (3,1) etc. Das Anschlußmodul 39 kennt nun alle besetzten Positionen der Matrix sowie die Identitäten (Typen) der vorhandenen Funktionsmodule. Diese Konfiguration ist deshalb wichtig, weil jedem Klingeltaster 3 aller vorhandenen Tastenmodule 46 eine bestimmte und eindeutige Adresse zugeordnet werden muß, die in dem zum Klingeltaster 3 gehörenden Haustelefon 40, 40' eingestellt wird. Auch kann durch die Konfiguration geprüft werden, ob innerhalb der Türstation 1 bzw. 1' Funktionsprobleme vorliegen. Weiterhin ist es ein besonderer Vorteil, daß die installierende Person ohne spezifische Fachkenntnisse eine Türstation beliebig zusammenstellen kann, ohne sich um die interne Verdrahtung kümmern zu müssen.

Erfindungsgemäß steuert das Video-Umschaltmodul 42 - das einerseits mit den Türstationen 1 bzw. 1' und andererseits mit den Monitoren 41 bzw. 41' über den Video-Zweidraht-Bus 44 verbunden ist die Hauskommunikationsanlage so, daß immer nur die Türstation 1 bzw. 1', von der aus geklingelt wurde, über den Video-Zweidraht-Bus 44 mit dem angewählten Monitor 41 bzw. 41' verbunden ist. Dadurch wird sichergestellt, daß sich Signale unterschiedlicher Videomodule 48 nicht überlagern.

Die Hauskommunikationsanlage funktioniert nun wie folgt:

Wenn jemand an einem Klingeltaster 3 eines Tastenmoduls 46 oder 46' klingelt, schaltet sich die Video-Kamera 6 des entsprechenden Videomoduls 46 bzw. 46' ein. Das Video-Umschaltmodul 42 erhält die Information, von welcher Türstation 1 bzw. 1' aus geklingelt wurde, über ein bestimmtes Steuersignal über den Sprach-Zweidraht-Bus 45 vom Anschlußmodul 39 bzw. 39'. Wurde z.B. am Tastenmodul 46 der Türstation 1 geklingelt, meldet nur das Anschlußmodul 39 ein Steuersignal A an das Video-Umschaltmodul 42. Wurde z.B. am Tastenmodul 46' der Türstation 1' geklingelt, meldet das Anschlußmodul 39' ein Steuersignal B an das Video-Umschaltmodul 42. Das Video-Umschaltmodul 42 schaltet nun in Richtung der aktiven Türstation 1 bzw. 1' um. Das angeklingelte Haustelefon 40 oder 40' schaltet sich und auch gleichzeitig den dazugehörigen Monitor 41 bzw. 41' ein, so daß das Video-Bild am richtigen Monitor 41 bzw. 41' sichtbar ist.

Vorteilhafterweise ist bei der beschriebenen Hauskommunikationsanlage das VideoUmschaltmodul 42 auch über eine "Bildhol-Taste" am Monitor -41 bzw. 41' steuerbar, so daß die einzelnen Videomodule 48 bzw. 48' der einzelnen Türstationen 1 bzw. 1' und/oder zusätzliche externe Videokameras 49, 49' nacheinander aktiviert werden können. Durch die "Bildhol-Taste" am Monitor 41 bzw. 41' wird über den Sprach-Zweidraht-Bus 45 ein Steuersignal zum Video-Umschaltmodul 42 und zu den angeschlossenen Türstationen 1 und 1' gesendet. Das Steuersignal bewirkt einerseits im Anschlußmodul 39 bzw. 39', daß die dazugehörige Video-Kamera des entsprechenden Videomoduls 46 bzw. 46' eingeschaltet wird, andererseits, daß mit jedem neuen Tastendruck auf die "Bildhol-Taste" das Video-Umschaltmodul 42 jeweils zum nächsten Videomodul 48 bzw. 48' bzw. zur nächsten externen Video-Kamera 49 bzw. 49' umschaltet. So kann durch das Aufrufen der einzelnen Videomodule 48 bzw. 48' bzw. der einzelnen externen Video-Kameras 49, 49' auch eine Umgebungsüberwachung durchgeführt werden.

Für die Eingänge der externen Videokameras 49, 49' enthält das Video-Umschaltmodul 42 idealerweise eine spezielle elektronische Schaltung, die es ermöglicht, das Koaxialkabel 50 der externen Videokameras 49, 49' mit dem Video-Zweidraht-Bus 44 der Hauskommunikationsanlage zu verbinden (Videozweidraht-Umsetzer). Dadurch können handelsübliche Video-Kameras ohne weitere Zusatzgeräte angeschlossen werden. In den Videomodulen 48 und 48' der Türstationen 1 und 1' ist dieser Videozweidraht-Umsetzer bereits integriert.

## Patentansprüche

1. Türstation einer aus Türstationen und Wohnungsstationen in einem Gebäude zu bildenden Türanlage mit mehreren Funktionsmodulen, die jeweils zumindest ein Funktionselement - wie Klingeltaster, Lautsprecher, Mikrofon, Videokamera, Bewegungsmelder - sowie mechanische Verbindungselemente und elektrische Verbindungselemente umfassen und die jeweils eine Modulbasis, eine Leiterplatte, eine Frontplatte und ggfs. einen Trägereinsatz umfassen, wobei die Funktionsmodule in Aufsicht rechteckig, insbesondere quadratisch sind und Umfangskanten gleicher Höhe aufweisen und mit den mechanischen Verbindungselementen mit ihren Umfangskanten aneinander grenzend zu einer selbsttragenden Einheit aus in Zeilen und/oder Spalten angeordneten Funktionsmodulen verbindbar sind, und wobei die Funktionsmodule Befestigungsmittel zur unmittelbaren Befestigung der Einheit an einem gebäudeseitigen ortsfesten Wandelement - Mauerwerk mit Aufputz, Umrahmung einer Haustüranlage - aufweist.

2. Türstation nach Anspruch 1,
wobei ein die Einheit einfassender nichttragender Rahmen unmittelbar mit der Einheit verbindbar ist, der auf dem gebäudeseitigen ortsfesten Wandelement verbindungslos aufliegt.

3. Türstation nach einem der Ansprüche 1 oder 2,
wobei die mechanischen Verbindungsmittel an den Umfangskanten der Funktionsmodule angeordnete komplementär ineinandergreifende Laschen und Schlitze sind, wobei die Verbindungen mit die Laschen durchsetzenden Stiften oder Schrauben gesichert sind.

4. Türstation nach einem der Ansprüche 1 bis 2,
wobei die mechanischen Verbindungsmittel an den Umfangskanten der Funktionsmodule angeodnete komplemetär ineinandergreifende Laschen und Schlitze sind, wobei die Verbindungen durch in Formvorsprünge an den Laschen greifende Rastklinken gesichert sind.

5. Türstation nach einem der Ansprüche 1 bis 4,
wobei die Einheit mit den Befestigungsmitteln auf der Oberfläche des Wandelements aufliegend montierbar ist.

6. Türstation nach einem der Ansprüche 1 bis 4,
wobei die Einheit mit den Befestigungsmitteln in eine Öffnung des Wandelements eingesetzt - insbesondere bündig versetzt - montierbar ist.

7. Türstation nach einem der Ansprüche 1 bis 6,
wobei die Befestigungsmittel höhenverbiegbare Laschen mit Schraubenlöchern sind.

8. Türstation nach einem der Ansprüche 1 bis 7,
wobei die Leiterplatten zumindest an zwei gegenüberliegenden Kanten Steckplätze haben, deren Steckkontakte mit parallelverlaufenden gedruckten Leitern paarweise miteinander verbunden sind, wobei mit den elektrischen Verbindungsmitteln eine Busstruktur in Zeilen oder in Spalten herstellbar ist.

9. Türstation nach einem der Ansprüche 1 bis 7,
wobei die Leiterplatten an jeder ihrer Kanten Steckplätze haben, deren Steckkontakte mit kreuzweise verlaufenden zueinander mit ihren Kreuzungspunkten diagonal versetzten gedruckten Leitern quadrupelweise verbunden sind, wobei mit den elektrischen Verbindungsmitteln eine Busstruktur in Zeilen und/oder in Spalten herstellbar ist.

10. Türstation nach einem der Ansprüche 1 bis 9,
wobei die Steckkontakte als gedruckte Kontakte auf den Leiterplatten ausgebildet sind und die elektrischen Verbindungsmittel weiterhin symmetrische klemmenartige Leiterplattenverbinder umfassen.

11. Türstation nach einem der Ansprüche 1 bis 10,
wobei die Leiterplatten jeweils unmittelbar in eine Modulbasis eingesetzt sind.

12. Türstation nach einem der Ansprüche 1 bis 10,
wobei die Leiterplatten jeweils in einem Trägereinsatz eingesetzt sind, der seinerseits unmittelbar mit der Modulbasis verbunden ist.

13. Türstation nach einem der Ansprüche 1 bis 12,
wobei ein Trägereinsatz aus transparentem Kunststoff besteht und Lichtleiterfunktion zwischen auf der Leiterplatte befestigten Leuchtmitteln und Lichtaustrittsöffnungen in der Frontplatte hat.

14. Türstation nach einem der Ansprüche 1 bis 13,
wobei ein Trägereinsatz aus transparentem Kunststoff besteht und Lichtleiterfunktion zwischen auf der Leiterplatte befestigten Lichtsensormitteln und einer Lichteintrittsöffnung in der Frontplatte hat.

15. Türstation nach einem der Ansprüche 1 bis 14,
wobei- ein Funktionsmodul einen Helligkeitssensor und eine Steuerschaltung umfaßt, die helligkeitsabhängig eine Verknüpfung der Klingelbetätigung an der Einheit mit einer Betätigung einer zeitgeschalteten Hausbeleuchtung zuschalten oder abschalten.

16. Türstation nach einem der Ansprüche 1 bis 15,
wobei ein Funktionsmodul einen Helligkeitssensor und eine Steuerschaltung umfaßt, die helligkeitsabhängig eine Beleuchtung von Namensfeldern an der Einheit zuschalten oder abschalten.

17. Türstation nach einem der Ansprüche 1 bis 16,
wobei ein Trägereinsatz aus Kunststoff besteht und einen Lautsprecher mit einer Lochplatte zur Abdeckung aufnimmt und wobei die Frontplatte als Lochplatte ausgebildet ist, wobei die Lochraster der beiden Lochplatten zueinander versetzt sind.

18. Türstation nach einem der Ansprüche 1 bis 17,
wobei ein Trägereinsatz aus transparentem Kunststoff besteht und prismenförmige Reflexionsmittel aufweist, die eine Lichtversorgung einer Beleuchtung für ein in der Frontplatte eingelassenes Namensschild durch ein auf der Leiterplatte befestigtes Leuchtmittel bewirken.

19. Türstation nach einem der Ansprüche 1 bis 18,
wobei ein Funktionsmodul eine Fehlererkennungsschaltung und eine Leuchtanzeige zur Darstellung ordnungsgemäßer Schaltung und/oder zur Darstellung eines Fehlerstatus aufweist.

20. Türstation nach Anspruch 19,
wobei zumindest ein Funktionsmodul einen Rücksetzknopf für die Fehlererkennungsschaltung aufweist.

21. Türstation nach einem der Ansprüche 1 bis 20,
wobei in einem Trägereinsatz durch eine elastische Membran nach außen abgedichtete Tasterelemente angeordnet sind, auf denen Tasterknöpfe aufliegen, die von der Frontplatte beweglich gehalten sind.

22. Türstation nach einem der Ansprüche 1 bis 21,
wobei für Einheiten mit nur zeilenförmiger Busstruktur oder nur spaltenförmiger Busstruktur Steckverbinderbrücken aus zwei miteinander elektrisch verbundenen Steckverbindern zur Verbindung benachbarter Spaltenbusse oder Zeilenbusse vorgesehen sind.

23. Türstation nach einem der Ansprüche 1 bis 22,
wobei ein Trägereinsatz eine Mehrzahl von durch Wände gebildeten Aufnahmeabteilen umfaßt, die wahlweise mit verschiedenen Funktionsteilen zur Verwendung in verschiedenen Funktionsmodulen bestückbar sind.

24. Türstation nach Anspruch 23,
wobei der Trägereinsatz einen Deckel umfaßt, der die Funktionsteile hält.

25. Türstation nach Anspruch 23,
wobei die Funktionsteile in den Aufnahmeabteilen verklebt oder vergossen sind.
